# FASCICULE DE BREVET EUROPEEN

(11) **EP 1 922 808 B1**
(45) Date de publication et mention de la délivrance du brevet: **28.10.2015**
(21) Numéro de dépôt: 06777452.1
(22) Date de dépôt: 23.06.2006
(51) Int. Cl.: H03F 3/45

(54) **CIRCUIT ELECTRONIQUE A RESEAU DE PAIRES DIFFERENTIELLES DISYMETRIQUES**
ELEKTRONISCHE NETZWERKSCHALTUNG MIT DISYMMETRISCHEN DIFFERENZ-PAAREN
ELECTRONIC NETWORK CIRCUIT WITH DISYMMETRICAL DIFFERENTIAL PAIRS

(30) Priorité: 28.06.2005 FR 0506564
(43) Date de publication de la demande: 21.05.2008
(73) Titulaire: E2V Semiconductors, 38521 Saint Egreve (FR)
(72) Inventeur: BORE, François, F-38100 Grenoble (FR); BRUEL, Sandrine, F-38000 Grenoble (FR); WINGENDER, Marc, F-38120 Saint Egreve (FR)
(74) Mandataire: Guérin, Michel
(86) Numéro de dépôt international: PCT/EP2006/063518
(87) Numéro de publication internationale: WO 2007/000423

(56) Documents cités:
- GB-A- 2 195 211
- US-A- 4 379 268
- US-A- 5 376 937
- US-A- 5 416 484

## Description

L'invention concerne les circuits électroniques à transistors, et plus particulièrement les circuits analogiques qui utilisent pour leur fonctionnement des ensembles de plusieurs paires différentielles de transistors.

Par "paire différentielle de transistors", on entend ici un ensemble de deux branches parallèles comportant chacune un transistor ayant un émetteur une base et un collecteur, les émetteurs étant réunis entre eux et étant alimentés par une source de courant commune de telle sorte que le courant de la source ne peut que se partager entre les deux transistors. Les bases des transistors reçoivent des tensions électriques différentes et c'est la différence entre ces tensions qui règle les proportions de ce partage. La source de courant est par ailleurs reliée à une première borne d'alimentation en énergie. Les collecteurs des transistors sont reliés, directement ou indirectement, à une autre borne d'alimentation.

Dans tout ce qui suit on utilisera l'appellation générique émetteur, base, collecteur de transistor (appellations en général utilisées pour des transistors bipolaires), même si les transistors sont des transistors à effet de champ (transistors MOS). Dans ce dernier cas, les mots émetteur, base et collecteur doivent être pris comme signifiant source, grille et drain respectivement (appellation en général utilisée pour des transistors MOS) ; l'invention est applicable aux circuits à transistors MOS de la même manière qu'aux circuits à transistors bipolaires.

Des applications typiques dans lesquelles on rencontre un réseau de plusieurs paires différentielles de transistors et pour lesquelles l'invention est applicable sont les suivantes :
- circuits de conversion analogique-numérique à multiples comparateurs, dans lesquels chaque comparateur comprend une paire différentielle recevant en entrée d'une part une tension à convertir, d'autre part une tension de référence ;
- circuits de conversion analogique-numérique à circuits de repliement, dans lesquels un étage de repliement comprend plusieurs cellules de repliement chacune constituée d'au moins une paire différentielle, les sorties en courant des cellules étant reliées les unes aux autres pour établir une tension ou un courant analogique de sortie qui varie en cloche ou en sinusoïde en fonction de la tension d'entrée à convertir, les différentes cellules recevant chacune la tension d'entrée et une tension de référence respective. Un tel invertisseur analogique-numerique est décrit par la publication US 5 416 484.

On rappelle que la tension base-émetteur d'un transistor bipolaire (à température supposée constante) est proportionnelle au logarithme du courant qui traverse l'émetteur ; et le courant qui traverse l'émetteur pour une tension base-émetteur donnée est proportionnel à la surface effective de l'émetteur ; il en résulte que deux transistors identiques d'une paire sont, au moins dans la théorie, parcourus par un même courant lorsque leurs bases sont portées au même potentiel.

Les circuits analogiques de conversion se fondent sur cette propriété pour établir une conversion précise, l'application d'une même tension à convertir et de plusieurs tensions de référence différentes à plusieurs paires différentielles permettant de situer très précisément la tension à convertir par rapport aux diverses tensions de référence.

Dans les circuits analogiques de précision utilisant plusieurs paires différentielles, on se rend compte cependant que des imprécisions de fonctionnement (notamment des imprécisions de conversion) peuvent résulter du fait que les tensions émetteur-base des différents transistors de ces paires ne sont pas exactement identiques même lorsqu'ils sont parcourus par des courants identiques.

En effet, les technologies ne sont pas parfaites et deux transistors fabriqués simultanément, ayant au moins théoriquement les mêmes surfaces d'émetteur, et même placés côte à côte dans un circuit intégré donc ayant toutes les chances d'être identiques, n'ont pas des caractéristiques rigoureusement identiques. Par conséquent, pour une même tension base-émetteur des deux transistors d'une paire différentielle, les émetteurs ne sont pas parcourus exactement par le même courant. Ou réciproquement, il faut appliquer entre les deux bases (les émetteurs étant supposés réunis) une légère tension de décalage (appelée aussi tension d'offset de la paire différentielle) pour qu'ils soient effectivement parcourus par le même courant.

Ceci résulte d'une dispersion de fabrication inévitable. De plus, du fait même de cette dispersion, les différentes paires différentielles d'un circuit intégré présentent inévitablement des tensions d'offset différentes les unes des autres.

A l'intérieur de l'ensemble de paires différentielles d'un même circuit à multiples paires on peut observer une dispersion de tensions d'offset qui répond à des lois statistiques, typiquement une gaussienne dont l'écart type est inversement proportionnel à la racine carrée de la surface effective d'émetteur du transistor. En effet, on constate que la dispersion est plus grande pour les petits transistors et plus faible pour les gros transistors.

Il est donc connu qu'on devrait utiliser de plus gros transistors pour améliorer la statistique d'appariement des paires différentielles et aboutir à une plus grande précision de conversion. Mais alors, les capacités sont plus grandes et les circuits sont donc plus lents, ce qui n'est pas souhaitable dans des applications telles que les convertisseurs analogiques-numériques rapides. Pour ces derniers, il vaudrait mieux avoir de plus petits transistors dans les paires différentielles.

Il est donc difficile de concilier à la fois ces deux caractéristiques de précision et de rapidité qui sont pourtant essentielles dans des circuits tels que des convertisseurs analogiques-numériques.

L'invention vise à trouver un meilleur compromis entre précision et rapidité en proposant une structure de convertisseur analogique-numérique ayant une dispersion de tensions d'offset de paires différentielles plus réduite, sans diminuer trop les performances en vitesse.

Pour cela, l'invention propose un convertisseur analogique-numérique comportant une paire différentielle double composée de deux paires différentielles simples identiques de deux transistors chacune, la paire différentielle double recevant un signal d'entrée différentiel qui est la différence entre une première et un deuxième tensions variables (Vinp, Vinn) appliquées respectivement chacune à un premier transistor respectif de chaque paire simple, et recevant par ailleurs un signal de référence fixe (Vrefp, Vrefn) appliqué à un deuxième transistor respectif de chaque paire différentielle simple, chaque paire simple étant alimentée par une source de courant respective reliée aux émetteurs des deux transistors de la paire de telle manière que le courant de la source se partage entre les émetteurs des transistors de la paire, caractérisé en ce que pour chacune des deux paires différentielles, le transistor qui reçoit une tension de référence fixe a une surface d'émetteur au moins deux fois plus grande que le transistor qui reçoit sur sa base une tension variable.

Le transistor qui reçoit une tension de référence fixe a de préférence une surface d'émetteur effective double de l'autre et pour cela il est de préférence constitué par deux transistors en parallèle, identiques au transistor qui reçoit la tension variable.

Le signal de référence fixe est de préférence lui-même un signal différentiel, qui est la différence entre deux tensions de référence fixes Vrefp et Vrefn appliquées respectivement à la base du deuxième transistor de chaque paire.

De cette disposition il résulte que
- on se contente d'un petit transistor du côté qui reçoit la tension variable ; il peut donc être rapide ; le plus gros transistor reçoit une tension fixe et il importe relativement peu que sa capacité d'entrée soit plus grande puisque sa tension d'entrée ne varie pas ;
- l'écart-type σ de la dispersion d'offset d'un groupe de transistors qui comprend des transistors ayant une dispersion gaussienne d'écart-type σ1 (petits transistors) et des transistors ayant une dispersion gaussienne d'écart-type σ2 (gros transistors) est la racine carrée de la demi-somme des carrés des écarts-types. Cet écart-type σ est intermédiaire entre les écarts-types σ1 et σ 2, ce qui est plus favorable que si c'était l'écart-type σ1 des petits transistors.

On a donc gagné en dispersion, donc en précision, sans pratiquement perdre en rapidité.

L'invention est particulièrement intéressante pour la réalisation de convertisseurs qui comportent un ensemble de paires différentielles doubles, c'est-à-dire des paires comportant chacune deux paires différentielles simples (à deux transistors) comme définies précédemment.

La paire différentielle double reçoit un signal d'entrée différentiel qui est la différence entre une première et une deuxième tensions variables, appliquées respectivement chacun à l'une des paires simples, et elle reçoit par ailleurs un signal de référence différentiel qui est la différence entre deux tensions de référence appliquées respectivement chacune à l'une des paires différentielles simples.

L'invention s'applique notamment aux convertisseurs analogiques utilisant des circuits à repliement de signal ou des comparateurs à paires différentielles doubles.

D'autres caractéristiques et avantages de l'invention apparaîtront à la lecture de la description détaillée qui suit et qui est faite en référence aux dessins annexés dans lesquels :
- la figure 1 représente une paire différentielle double selon l'invention ;
- la figure 2 représente une autre réalisation ;
- la figure 3 représente une application à un circuit de repliement pour un convertisseur analogique-numérique ;
- la figure 4 représente une application à un comparateur analogique-numérique de type flash.

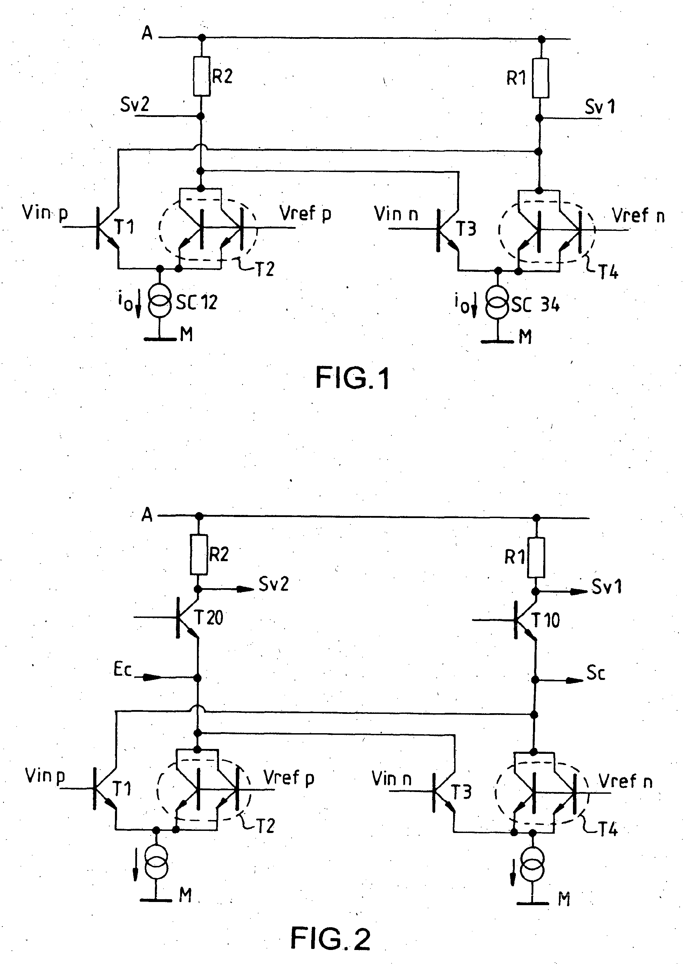

La figure 1 représente un exemple de paire différentielle selon l'invention, qui fait partie d'un convertisseur analogique-numérique à multiples paires différentielles.

La paire différentielle est une paire différentielle double comprenant quatre transistors T1, T2, T3, T4 agencés en deux paires différentielles simples T1, T2 et T3, T4.

La paire simple T1, T2 reçoit une tension d'entrée variable Vinp sur la base du transistor T1 et une tension de référence fixe Vrefp sur la base du transistor T2. De même la paire simple T3, T4 reçoit une tension d'entrée variable Vinn sur la base du transistor T3 et une tension de référence fixe Vrefn sur la base du transistor T4. Les émetteurs de T1 et T2 sont reliés à une même source de courant SC12 de valeur i₀ reliée par ailleurs à une masse commune M, et les émetteurs de T3 et T4 sont reliés à une même source SC34 de même valeur i₀ reliée à la masse. La paire double a donc pour entrées d'une part un signal différentiel variable Vinp-Vinn et d'autre part un signal différentiel de référence Vrefp-Vrefn.

Les collecteurs des deux paires sont réunis de manière croisée : collecteur de T1 relié au collecteur de T4 ; collecteur de T2 relié au collecteur de T3. Ces deux paires de collecteurs constituent des sorties en tension ou en courant Sv1 et Sv2 respectivement, mais elles peuvent aussi constituer des entrées en courant dans des montages à repliement. La première paire de collecteurs est chargée par une résistance R1 (ou par une charge plus complexe telle qu'un transistor en série avec une résistance) reliée à une borne d'alimentation A. De même, la deuxième paire est chargée par une résistance R2 identique à R1 et reliée à la même borne A.

Cette cellule différentielle double est destinée à comparer une tension différentielle d'entrée Vinp-Vinn à une tension différentielle de référence Vrefp-Vrefn, ou bien, si on utilise aussi les collecteurs comme entrées et sorties en courant, elle peut servir à être connectée à d'autres cellules semblables de manière à constituer un circuit de repliement de signal produisant une tension analogique variant en forme de cloche ou de sinusoïde en fonction de la tension différentielle d'entrée.

Dans la cellule de l'invention, les transistors T2 et T4 qui reçoivent les tensions de référence Vrefp et Vrefn sont plus gros (au moins deux fois plus gros) que les transistors T1 et T3 qui reçoivent les tensions variables Vinp et Vinn. De préférence ils sont exactement deux fois plus gros et ils sont constitués chacun par deux transistors en parallèle, identiques chacun aux transistors T1 et T3. C'est ce qui a été représenté sur la figure 1.

La figure 2 représente un exemple de cellule légèrement différente, dans laquelle les chargés de collecteur sont des ensembles en série d'un transistor et d'une résistance : T10 est en série avec R1 et intercalé entre R1 et les collecteurs de T1 et T4 ; T20 est en série avec R2 et intercalé entre R2 et les collecteurs de T2 et T3.

Dans un circuit de repliement, les collecteurs de T1 et T4 réunis forment une entrée en courant Ec destinée à être reliée à la sortie en courant d'une cellule précédente ; les collecteurs de T2 et T3 réunis forment une sortie en courant Sc destinée à être reliée à l'entrée en courant d'une cellule suivante.

Les points de jonction entre le transistor T10 et la résistance R1 ou le transistor T20 et la résistance R2 constituent des sorties en tension Sv1 et Sv2 si on en a besoin.

Comme à la figure 1, les transistors T2 et T4 selon l'invention sont des doubles transistors alors que les transistors T1 et T3 sont simples.

Dans un ensemble de paires différentielles, la dispersion de valeur des tensions base-émetteur pour un même courant dans les transistors présente un écart-type inversement proportionnel à la surface effective d'émetteur. Ainsi, si l'écart-type est σ1 pour les transistors T1 et T3, alors l'écart type pour les transistors T2 et T4 est σ2 = σ1.2^{-1/2}.

Alors, la distribution des tensions d'offset (différences de tension base-émetteur pour un même courant dans deux transistors d'une paire) présente un écart-type qui est la racine carrée de la demi-somme des écarts-types des deux transistors. C'est donc un écart-type σ = [σ1²+σ1²/2]^{1/2}, soit (3^{1/2}.σ1)/2, soit encore environ 0,86.σ1, représentant un gain de 14% sur l'écart-type de la dispersion. En effet l'écart-type de l'offset serait σ1 si les transistors T1 et T2 étaient identiques.

Si les transistors T2 et T4 étaient trois fois plus gros que T1 et T3, on gagnerait encore en écart-type, qui deviendrait 0,82.σ1, mais le gain supplémentaire qui en résulte n'est pas très important et il est préférable, pour des raisons d'encombrement en tout cas, de ne pas grossir encore les transistors T2 et T4.

On notera que le déséquilibre des transistors T1 et T2 selon l'invention aboutit à un offset systématiquement non nul puisqu'une tension identique sur les deux bases de la paire aboutit à des courants en proportion des surfaces d'émetteur. Le plus souvent cet offset systématique n'est pas gênant car on ne s'intéresse qu'à des différences et non à des valeurs absolues. De plus, cet offset systématique ne joue de toutes façons aucun rôle dans les paires différentielles doubles car il s'élimine naturellement.

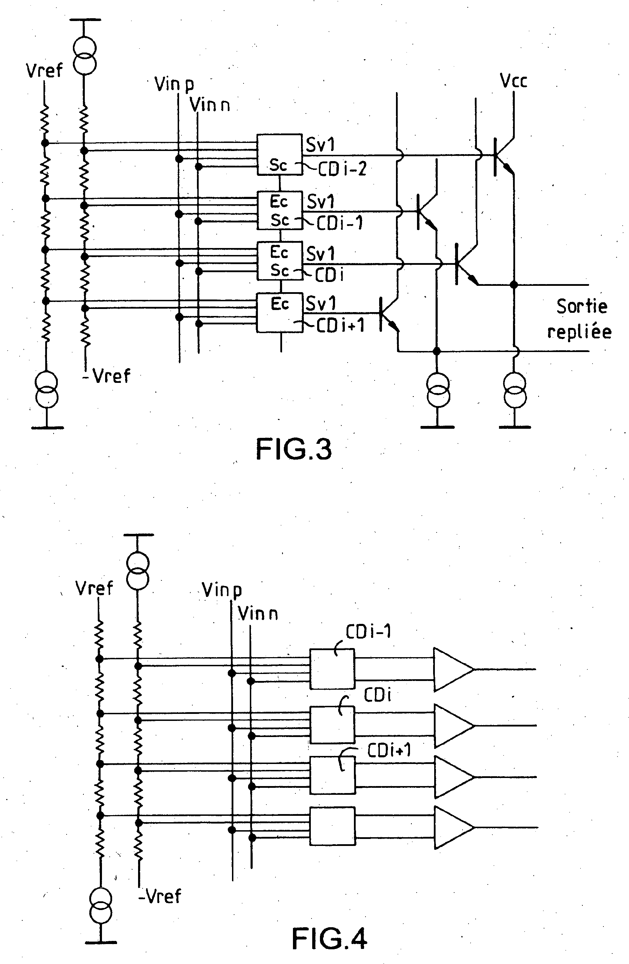

La figure 3 représente une application de la cellule de la figure 2 a la réalisation d'un circuit de repliement dans un comparateur analogique-numérique.

Des tensions de référence sont produites par deux ponts de résistances de précision alimentés par des tensions opposées Vref et -Vref. Des couples de tensions de référence respectives prélevées sur les deux ponts sont appliqués aux transistors T2 et T4 des différentes cellules différentielles doubles, lesquelles sont désignées par CDᵢ₋₂, CDᵢ₋₁, CDᵢ, CDᵢ₊₁ pour les quatre cellules adjacentes représentées.

Toutes ces cellules reçoivent par ailleurs la tension à convertir, sous forme d'une tension différentielle Vinp, Vinn appliquée comme expliqué précédemment aux bases des transistors T1 et T3.

L'entrée en courant Ec d'une cellule de rang i est reliée à la sortie en courant Sc de la cellule de rang i-1 ; la sortie en courant de la cellule de rang i est reliée à l'entrée en courant de la cellule i-1.

Les sorties en tension Sv des cellules de rang impair (i-1, i+1, ...) sont reliées à un circuit OU câblé analogique, et les sorties en tension Sv des cellules de rang pair (i-2, i, i+2, etc.) sont reliées à un autre circuit OU câblé. Les sorties de ces deux circuits OU câblé définissent une sortie différentielle repliée pouvant servir dans un convertisseur analogique à repliement.

Les circuits OU câblé comprennent classiquement deux transistors ayant leurs collecteurs à une borne d'alimentation, leurs émetteurs reliés à une source de courant, leurs bases recevant les tensions Sv. La sortie du OU câblé est prélevée sur les émetteurs réunis.

La figure 4 représente une application des paires différentielles doubles, selon l'invention, à un convertisseur analogique-numérique de type flash : chaque paire différentielle double telle que celles des figures 1 et 2 constitue un circuit à quatre entrées et deux sorties et elle est suivie d'un comparateur.

## Revendications

1. Convertisseur analogique-numérique comportant une paire différentielle double composée de deux paires différentielles simples identiques de deux transistors chacune (T1, T2 ; T3, T4), la paire différentielle double recevant un signal d'entrée différentiel à convertir qui est la différence entre une première et un deuxième tensions variables (Vinp, Vinn) appliquées respectivement chacune à la base d'un premier transistor respectif de chaque paire simple, et recevant par ailleurs un signal de référence fixe (Vrefp, Vrefn) appliqué à la base d'un deuxième transistor respectif de chaque paire différentielle simple, le collecteur du premier transistor de chaque paire étant relié au collecteur du deuxième transistor de l'autre paire, chaque paire simple étant alimentée par une source de courant respective reliée aux émetteurs des deux transistors de la paire de telle manière que le courant de la source se partage entre les émetteurs des transistors de la paire, **caractérisé en ce que** pour chacune des deux paires différentielles, le transistor (T2, T4) qui reçoit une tension de référence fixe a une surface d'émetteur au moins deux fois plus grande que le transistor (T1, T3) qui reçoit sur sa base une tension variable.

2. Convertisseur analogique-numérique selon la revendication 1, **caractérisé en ce que** le transistor qui reçoit une tension de référence fixe a une surface effective d'émetteur double de l'autre.

3. Convertisseur analogique-numérique selon la revendication 2, **caractérisé en ce que** le transistor qui reçoit une tension de référence fixe est constitué par deux transistors en parallèle, identiques au transistor qui reçoit la tension variable.

4. Convertisseur analogique-numérique selon l'une des revendications précédentes, **caractérisé en ce que** le signal de référence fixe est un signal différentiel qui est la différence entre dieux tensions de référence (Vrefn, Vrefp) appliquées respectivement à la base du deuxième transistor de chacune des paires.

5. Application du circuit intégré selon l'une des revendications 1 à 4 à un circuit analogique à repliement de signal à multiples paires différentielles.

6. Application du circuit intégré selon l'une des revendications 1 à 4 à un convertisseur analogique-numérique de type flash utilisant des comparateurs à paires différentielles doubles.

## Patentansprüche

1. Analog-Digital-Wandler, der ein doppeltes Differenzpaar umfasst, bestehend aus zwei einfachen identischen Differenzpaaren von jeweils zwei Transistoren (T1, T2; T3, T4), wobei das doppelte Differenzpaar ein umzuwandelndes Differenz-Eingangssignal erhält, das die Differenz zwischen einer ersten und einer zweiten variablen Spannung (Vinp, Vinn) ist, die jeweils an eine Basis eines jeweiligen ersten Transistors jedes einfachen Paares angelegt werden, und ferner ein festes Referenzsignal (Vrefp, Vrefn) erhält, das an die Basis eines jeweiligen zweiten Transistors jedes einfachen Differenzpaares angelegt wird, wobei der Kollektor des ersten Transistors jedes Paares mit dem Kollektor des zweiten Transistors des anderen Paares verbunden ist, wobei jedes einfache Paar von einer jeweiligen Stromquelle gespeist wird, die mit den Emittern der zwei Transistoren des Paares so verbunden sind, dass der Strom von der Quelle zwischen den Emittern der Transistoren des Paares aufgeteilt wird, **dadurch gekennzeichnet, dass** für jedes der zwei Differenzpaare der Transistor (T2, T4), der eine feste Referenzspannung erhält, eine Emitterfläche von wenigstens dem Zweifachen der Größe des Transistors (T1, T3) hat, der eine variable Spannung an seiner Basis erhält.

2. Analog-Digital-Wandler nach Anspruch 1, **dadurch gekennzeichnet, dass** der Transistor, der eine feste Referenzspannung erhält, eine effektive Emitterfläche vom Zweifachen der anderen hat.

3. Analog-Digital-Wandler nach Anspruch 2, **dadurch gekennzeichnet, dass** der Transistor, der eine feste Referenzspannung erhält, von zwei parallelgeschalteten Transistoren gebildet wird, die mit dem Transistor identisch sind, der die variable Spannung erhält.

4. Analog-Digital-Wandler nach einem der vorherigen Ansprüche, **dadurch gekennzeichnet, dass** das feste Referenzsignal ein Differenzsignal ist, das die Differenz zwischen zwei Referenzspannungen (Vrefn, Vrefp) ist, die jeweils an die Basis des zweiten Transistors von jedem der Paare angelegt werden.

5. Anwenden der integrierten Schaltung nach einem der Ansprüche 1 bis 4 auf eine analoge Schaltung mit Signalfaltung an mehreren Differenzpaaren.

6. Anwenden der integrierten Schaltung nach einem der Ansprüche 1 bis 4 auf einen Analog-Digital-Wandler des Flash-Typs, der Komparatoren mit doppelten Differenzpaaren benutzt.

## Claims

1. An analog-to-digital converter comprising a dual differential pair composed of two identical single differential pairs of two transistors each (T1, T2; T3, T4), the dual differential pair receiving a differential input signal to convert which is the difference between a first and a second variable voltage (Vinp, Vinn) each applied respectively to the base of a first respective transistor of each single pair, and further receiving a fixed reference signal (Vrefp, Vrefn) applied to the base of a second respective transistor of each single differential pair, the collector of the first transistor of each pair being connected to the collector of the second transistor of the other pair, each single pair being powered by a respective current source connected to the emitters of the two transistors of the pair in such a way that the current from the source is shared between the emitters of the pair's transistors, **characterized in that** for each of the two differential pairs, the transistor (T2, T4) that receives a fixed reference voltage has an emitter surface at least twice as large as the transistor (T1, T3) that receives a variable voltage at its base.

2. The analog-to-digital converter as claimed in claim 1, **characterized in that** the transistor that receives a fixed reference voltage has an effective emitter surface double the other.

3. The analog-to-digital converter as claimed in claim 2, **characterized in that** the transistor that receives a fixed reference voltage consists of two transistors in parallel, identical to the transistor that receives the variable voltage.

4. The analog-to-digital converter as claimed in one of the preceding claims, **characterized in that** the fixed reference signal is a differential signal, which is the difference between two reference voltages (Vrefp, Vrefn) applied respectively to the base of the second transistor of each of the pairs.

5. An application of the integrated circuit as claimed in one of the claims 1 to 4 to an analog signal folding circuit with multiple differential pairs.

6. An application of the integrated circuit as claimed in one of the claims 1 to 4 to a flash type analog-to-digital converter using dual differential pair comparators.
